# EUROPÄISCHE PATENTSCHRIFT

(11) **EP 3 057 234 B1**
(45) Veröffentlichungstag und Bekanntmachung des Hinweises auf die Patenterteilung: **21.11.2018**
(21) Anmeldenummer: 16153207.2
(22) Anmeldetag: 28.01.2016
(51) Int. Cl.: H03K 17/955

(54) **SENSORANORDNUNG FÜR EIN KRAFTFAHRZEUG**
SENSOR ASSEMBLY FOR A MOTOR VEHICLE
SYSTÈME DE CAPTEURS POUR UN VÉHICULE AUTOMOBILE

(30) Priorität: 11.02.2015 DE 102015101959; 18.08.2015 DE 102015113663
(43) Veröffentlichungstag der Anmeldung: 17.08.2016
(73) Patentinhaber: Huf Hülsbeck & Fürst GmbH & Co. KG, 42551 Velbert (DE)
(72) Erfinder: SIEG, Berthold, 46240 Bottrop (DE)
(74) Vertreter: Zenz Patentanwälte Partnerschaft mbB

(56) Entgegenhaltungen:
- WO-A1-2008/137980
- WO-A1-2013/182464
- DE-A1-102012 022 927
- DE-A1-102012 111 447
- DE-A1-102013 105 539
- DE-A1-102014 101 775

## Beschreibung

Die Erfindung betrifft eine Sensoranordnung für ein Kraftfahrzeug. Insbesondere betrifft die Erfindung eine Sensoreinrichtung, die eine Steuer- und Auswerteeinrichtung aufweist und wenigstens eine mit dieser Steuer- und Auswerteeinrichtung gekoppelte Sensorelektrode. Die Sensorelektrode ist vorzugsweise als Leiterschleife oder als Koaxialkabel ausgebildet, welche(s) an zwei Kontaktstellen mit der Steuer- und Auswerteschaltung gekoppelt ist. Die Steuer- und Auswerteschaltung weist eine Messschaltung auf, welche die Sensorelektrode auf Kapazitätsänderungen hin überwacht.

Sensoranordnungen der eingangs genannten Art werden im Bereich der Fahrzeugtechnik eingesetzt, um eine Annäherung von Objekten zu erfassen und eine Bedienung des Fahrzeuges komfortabler zu gestalten.

Insbesondere werden derartige Sensoreinrichtungen mit kapazitiven Elektrodenschleifen im Heckbereich eines Fahrzeuges eingesetzt. Erstreckt sich die Sensorelektrode über einen Bereich des Fahrzeughecks, so kann ein Benutzer durch bloße Annäherung oder Gestenausführung in dem Erfassungsbereich der Sensoreinrichtung beispielsweise eine Öffnung der Heckklappe auslösen. In diesem Vorgang wird bei Detektion eines Bedienwunsches vor einer Öffnung die Legitimation des Benutzers abgefragt, der üblicherweise einen drahtlosen Funkschlüssel zur drahtlosen Abfrage der Legitimation mit sich führt.

Für kapazitive Sensoren an Fahrzeugen sind am Markt Schaltungen und Lösungen verfügbar, welche die Kapazitätserfassung an verschieden gestalteten Sensorelektroden ermöglichen. Beispielsweise wird die Änderung der Kapazität einer Sensorelektrode erfasst, indem die Sensorelektrode mit einer vorgegebenen Frequenz wiederholt mit einer Betriebsspannung gekoppelt wird und der Lade- und Entladevorgang hinsichtlich einer Kapazitätsveränderung ausgewertet wird. Entsprechende Verfahren sind beispielsweise aus der US 5,730,165 bekannt. Ein anderer kapazitiver Sensor ist aus der Patentschrift EP 1 339 025 B1 oder aus der Patentschrift DE 10 2013 105539 A1 bekannt.

Einige der bekannten Sensoranordnungen weisen einen komplexeren Aufbau auf, z.B. sind sie zusätzlich zu der Sensorelektrode selbst mit sogenannten Schirmelektroden und ggf. separaten Masseelektroden ausgeführt. Dies dient dazu, den Erfassungsbereich der Sensorelektrode möglichst genau auf den gewünschten Bedienbereich anzupassen. Betreffende Veröffentlichungen sind beispielsweise die EP 0 518 836 A1, die DE 101 31 243 C1 oder auch die DE 10 2006 044 778 A1.

Ein Problem bei den bekannten Sensoranordnungen besteht darin, sowohl bei der Erstmontage und der anfänglichen Inbetriebnahme als auch im dauerhaften Betrieb sicherzustellen, dass eine ordnungsgemäße Kopplung der Sensorelektrode mit der Steuer- und Auswerteschaltung vorliegt. Bei schlaufenförmigen Sensorelektroden die an zwei Abgriffspunkten, beispielsweise an beiden Enden, mit der Steuer- und Auswerteschaltung gekoppelt sind, wird z.B. eine Durchgangsprüfung vorgenommen, um zu bestätigen, dass die Sensorelektrode in messfähiger Weise mit der Steuer- und Auswerteschaltung gekoppelt ist. Dieser Ansatz ist jedoch im Rahmen der verfügbaren Messgenauigkeiten und Komponenten ungenau und nicht verlässlich genug.

Verfahren zum Prüfen von kapazitiven Sensoren sind beispielsweise aus der WO 2008/137980 A1 bekannt.

Aufgabe der Erfindung ist es, eine verbesserte und universelle Sensoranordnung bereitzustellen, welche die verlässliche Prüfung einer Integrität der gesamten Anordnung erlaubt.

Diese Aufgabe wird erfindungsgemäß gelöst durch eine Sensoranordnung mit den Merkmalen des Patentanspruches 1.

Die erfindungsgemäße Sensoreinrichtung weist neben der Messschaltung auch eine zumindest zeitweise aktivierbare Prüfschaltung auf. Diese Prüfschaltung wird immer dann in Benutzung genommen, wenn die ordnungsgemäße Verbindung der Sensorelektrode mit der Steuer- und Auswerteschaltung verifiziert werden soll. Dies kann bei jedem Fahrzeugstart geschehen oder auch im festgelegten Zeitabständen oder bei anderen auslösenden Ereignissen.

Die Prüfschaltung dient dazu, die Integrität der Sensorelektrode und deren ordnungsgemäße Kopplung an die Steuer- und Auswerteschaltung zu prüfen. Dies wird von der Prüfschaltung realisiert, indem mittels einer ansteuerbaren Schalteinrichtung eine Prüfkapazität in der Steuer- und Auswerteeinrichtung zeitweise mit der Sensorelektrode gekoppelt wird. Die Prüfschaltung verfügt also über wenigstens eine Prüfkapazität und wenigstens eine Schalteinrichtung, die innerhalb der Steuer- und Auswerteeinrichtung ansteuerbar ist.

Wird die Prüfkapazität mit der Sensorelektrode gekoppelt, so hat dies den Effekt, dass die mit der Sensorelektrode gekoppelte Messschaltung, welche die Kapazität der Sensorelektrode erfasst, zusätzlich zu der eigentlichen Sensorelektrodenkapazität auch die Kapazität der Prüfkapazität erfasst. Die gemessenen Kapazitäten bei angekoppelter und abgekoppelter Prüfkapazität unterscheiden sich also deutlich. Beispielsweise kann dazu in der erfindungsgemäßen Sensoreinrichtung ein Schlaufenende der Sensorelektrode im Messbetrieb potentialfrei liegen, während der Aktivität der Prüfschaltung jedoch über eine Prüfkapazität mit Masse gekoppelt werden.

Es hat sich gezeigt, dass die Zuschaltung einer definierten Prüfkapazität, beispielsweise im Bereich von wenigen pF, sehr definierte und gut detektierbare Änderungen der Kapazitätsmesswerte bewirkt. Da die Messschaltung auf die Erfassung sehr geringer Kapazitätsänderungen ausgelegt ist, wird diese Eignung und Stärke der Messschaltung zur Integritätsprüfung herangezogen. Da die Messschaltung auf der einen Seite der Leiterschleife mit der Sensorelektrode gekoppelt ist und die Prüfschaltung auf der anderen Seite, insbesondere am anderen äußersten Ende der Sensorelektrode gekoppelt ist, liefert die definierte Veränderung der Messwerte einen klaren Hinweis darauf, dass die Sensorelektrode über ihre gesamte Länge in ihrer Integrität nicht beeinträchtigt ist. Wäre dies nicht der Fall, würde die Zuschaltung der Prüfkapazität am entfernten Ende keine Änderung der Messwerte in der Messschaltung hervorrufen.

Sowohl Messschaltung als auch Prüfschaltung befinden sich in der Steuer- und Auswerteeinrichtung und es ist daher eine besonders verlässliche Integritätsprüfung möglich, da die Informationen der Prüfschaltung, wann die Kapazität zugeschaltet wird, mit den Messwerten aus der Messschaltung korreliert werden kann. Für eine erfolgreiche Prüfung des Anschlusses und der Integrität der Sensorelektrode ist es erforderlich, dass bei Zuschaltung der Kapazität oder Wegschaltung der Kapazität eine signifikante Kapazitätsänderung mit der Messschaltung detektiert wird. Ist die Sensorelektrode beispielsweise abschnittsweise unterbrochen, was durch Unfälle oder einen Ermüdungsbruch geschehen kann, würde die Zuschaltung der Prüfkapazität keine wesentliche Änderung der Kapazität bewirken. Dann würde die Integritätsprüfung negativ ausfallen.

Die übrigen Komponenten der Steuer- und Auswerteinrichtung können derart ausgebildet sein, dass sie einerseits die Prüfschaltung aktivieren und andererseits die Korrelation der Messwerte aus der Messschaltung mit den Schaltzuständen der Prüfschaltung vornehmen.

In einer alternativen Gestaltung wird als Sensorelektrode eine koaxiale Leiteranordnung verwendet. Statt einer Leiterschleife kann die koaxiale Leiteranordnung (z.B. ein herkömmliches Koaxialkabel) mit der Steuer- und Auswerteeinrichtung gekoppelt werden.

In einer bevorzugten Gestaltung ist die Prüfkapazität aus einem definierten Kondensatorbauteil gebildet, beispielsweise einen Kondensator mit der Kapazität 0,5 pF - 10 pF. Es ist nicht erforderlich, Prüfkondensatoren mit hoher Präzision einzusetzen, da es auf die Kapazitätsänderungen und nicht einen absoluten Kapazitätswert ankommt.

Vorzugsweise weist die Prüfschaltung eine zweite Schalteinrichtung auf, welche das Entladen der Prüfkapazität zu Masse ermöglicht, wenn die Prüfkapazität von der Sensorelektrode entkoppelt ist.

Die Entladung der Prüfkapazität zwischen den Zeiten einer Kopplung der Prüfkapazität mit der Sensorelektrode stellt sicher, dass jederzeit gleichartige Ladungszustände der Prüfkapazität mit der Sensorelektrode vorliegen und daher reproduzierbare Bedingungen gewährleistet sind.

Es ist besonders vorteilhaft, wenn die Prüfkapazität wiederholt, gemäß einem in der Steuer- und Auswerteeinrichtung hinterlegten Zeitschema mit der Sensorelektrode gekoppelt wird. Anhand des hinterlegten Zeitschemas, welches Schaltvorgänge zu gewissen Zeitabständen zuordnet, weiß einerseits die Prüfschaltung, wann die Prüfkapazität mit der Sensorelektrode zu koppeln ist und andererseits kann die Steuer- und Auswerteeinrichtung mit erhöhter Sicherheit feststellen, ob die Verbindung der Elektrode mit der Steuer- und Auswerteschaltung und die Elektrodenintegrität gewährleistet ist. Die Messwerte werden nämlich mit demselben Zeitschema korreliert und es wird geprüft, ob sich die Messwerte gemäß demselben Zeitschema verändern wie die Kapazität mit der Sensorelektrode gekoppelt wurde. Die wiederholte und eindeutige Befolgung des Zeitschemas schafft eine besondere Sicherheit bei der Funktionsüberprüfung.

In einer bevorzugten Gestaltung der Erfindung weist die Sensorelektrode die Form einer Leiterschleife auf, welche in einem flexiblen Kunststoffprofil aufgenommen und geführt ist. Die Führung der Leiterschleife mit einem Kunststoffprofil, insbesondere einem flexiblen Gummiprofil, ist vorteilhaft, da so die Sensorelektrode mit ihrer Schlaufenform in einer definierten Form und Ausrichtung gehalten wird. Beispielsweise kann das Kunststoffprofil eine mittlere Stützwand aufweisen und zu beiden Seiten von der mittleren Stützwand Aufnahmen aufweisen. In einer der Aufnahmen wird der Hinlauf (die erste Hälfte) der Leiterschleife aufgenommen und auf der anderen Seite von der Trennwand der Rücklauf (die zweite Hälfte) der Leiterschleife. So ist jeweils eine Hälfte der Leiterschleifen zu jeweils einer Seite der Trennwand aufgenommen und die Hälften sind parallel geführt. Der Wendebereich in der Mitte der Leiterschleife kann freiliegen oder extra geschützt sein.

Die Erfindung wird nun anhand der beiliegenden Zeichnungen näher erläutert.
Figur 1 zeigt in schematischer Weise die Anordnung einer Ausführungsform der erfindungsgemäßen Sensoreinrichtung an einem Fahrzeug;
Figur 2 zeigt in schematischer Weise den Aufbau der Steuer- und Auswerteeinrichtung.

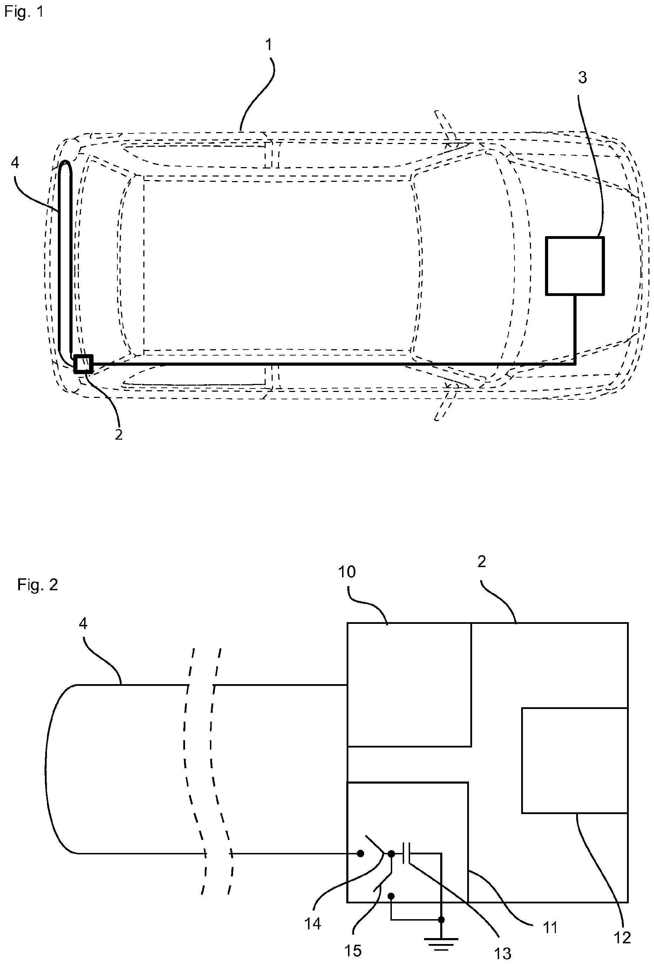

In Figur 1 ist ein Fahrzeug 1 gezeigt. Im Heckbereich des Fahrzeugs ist eine Steuer- und Auswerteeinrichtung 2 angeordnet, die mit einem zentralen Steuersystem 3 des Fahrzeuges über einen Kabelbaum verbunden ist. Mit der Steuer- und Auswerteeinrichtung 2 ist eine schlaufenförmige Sensorelektrode 4 verbunden. Die Sensorelektrode 4 erstreckt sich in einer länglichen Form entlang des hinteren Stoßfängers des Fahrzeugs. Die Schlaufe ist dabei derart in die Länge gezogen, dass Hinlauf und Rücklauf der Sensorelektrode im Wesentlichen parallel verlaufen, abgesehen von dem Wendebereich in der Mitte der Sensorelektrode.

Die Steuer- und Auswerteeinrichtung 2 ist in diesem Beispiel dezentral, auf einer Seite des Fahrzeuges angeordnet.

Figur 2 zeigt die Steuer- und Auswerteeinrichtung 2 und die damit gekoppelte Sensorelektrode 4 in schematischer Darstellung. Die Sensorelektrode 4 ist verkürzt dargestellt, was durch den durchbrochenen Bereich in der Mitte der Sensorelektrode gekennzeichnet ist.

Die Steuer- und Auswerteschaltung weist eine Messschaltung 10 auf. Außerdem ist eine Prüfschaltung 11 vorgesehen. Die Auswerteeinheit 12 empfängt Signale von der Messschaltung 10 und kann die Prüfeinheit 11 veranlassen, in den Prüfmodus zu wechseln.

In der dargestellten Konfiguration ist das untere Ende der Sensorelektrode 4 potentialfrei (floating). In dieser Gestaltung kann die Messschaltung 10 Kapazitätsänderungen an der Sensorelektrode 4, die sich gegenüber einem Messkörper oder der sonstigen Umgebung einstellen, erfassen. Dazu wird in der Messschaltung 10 eine der bekannten Schaltungen zur Kapazitätserfassung (siehe oben) angewendet. In diesem Ausführungsbeispiel lädt die Messschaltung 10 die Sensorelektrode 4 bei einem vorgegebenen Potential wiederholt auf und akkumuliert eine Ladung, die ein Maß für die Kapazität der Sensorelektrode 4 ist. Die Kapazitätswerte ermittelt die Messschaltung 10 und liefert sie an die Auswerteschaltung 12 innerhalb der Steuer- und Auswerteeinrichtung 2. Diese wertet die zeitlich einlaufenden Kapazitätswerte aus, um Bedienvorgänge zu erkennen und Bediensignale an die zentrale Steuereinheit 3 zu senden. Starke Änderungen der Kapazität deuten darauf hin, dass sich ein Benutzer annähert oder eine Geste in Richtung der Sensorelektrode ausgeführt wurde, was ein Bedienwunsch signalisiert. Die Auswerteschaltung 12 kann den zeitlichen Verlauf der Kapazitätsänderungen mit gespeicherten Verläufen und nach Kriterien auswerten, die im Stand der Technik hinreichend beschrieben sind. Die eigentliche Art der Erfassung einer Bedienung ist für diese Erfindung jedoch nicht wesentlich. Wesentlich für die Erfindung ist, dass die Prüfschaltung 11 das in Figur 1 potentialfrei dargestellte Ende der Sensorelektrode 4 mit einer Prüfkapazität 13 gegen Masse koppeln kann. In diesem Fall wird die Kapazität der Sensorelektrode 4 sprunghaft verändert, was die Messschaltung 10 detektiert und damit auch die Auswerteschaltung 12 erfasst. Die Kopplung mit der Prüfkapazität 13 erfolgt über einen Schalter 14, der durch die Prüfschaltung 11 zum Schließen oder Öffnen angesteuert wird. Ein Schließen und Öffnen erfolgt gemäß einem Zeitschema und einer darin codierten Zeitfolge, welche in der Steuer- und Auswerteschaltung 2 hinterlegt ist. Wird also die Prüfschaltung 11 zur Durchführung des Prüfverfahrens von der Auswerteschaltung 12 angesteuert, so folgt eine Zuschaltung oder Wegschaltung der Kapazität 13 zur Sensorelektrode 4 in vorgegebenen Zeitabständen.

Beispielsweise wird die Kapazität 13 für 20 ms zugeschaltet, dann für 10 ms weggeschaltet, anschließend wiederum für 15 ms zugeschaltet und schließlich für 30 ms weggeschaltet, bevor sie für weitere 20 ms zugeschaltet und dann dauerhaft weggeschaltet wird. Dieses Zeitschema ist in der Auswerteschaltung 12 ebenfalls bekannt oder abrufbar und die Auswerteschaltung 12 vergleicht die von der Messschaltung 10 eingehenden Messwerte hinsichtlich der charakteristischen Änderungen mit dem vorgegebenen Zeitschema. Korrelieren die Messwerte mit dem abgespeicherten Zeitschema, so ist klar, dass die Auswirkungen der Kapazität 13 über den gesamten Weg der Elektrode 4 bis zu der Messschaltung 10 gelangt sind. Diese Art der Prüfung hinsichtlich einer ordnungsgemäßen Kontaktierung der Sensorelektrode 4 mit der Einrichtung 2 ist wesentlich verlässlicher als beispielsweise eine Durchgangsprüfung oder eine Messung des ohmschen Widerstandes. Dies liegt insbesondere daran, dass die Messschaltung 10 auf die Erfassung von kleinen Kapazitätsänderungen ausgelegt ist und diese mit äußerst großer Sensitivität erfasst. Die Messschaltung arbeitet sowohl im Messbetrieb als auch im Prüfbetrieb auf dieselbe Weise, da sie jederzeit Kapazitätswerte erfassen wird.

Über eine Schalteinrichtung 15 ist es möglich, immer dann, wenn der Schalter 14 die Prüfkapazität 13 von der Sensorelektrode 4 entkoppelt, eine Entladung der Prüfkapazität 13 herzustellen. Selbstverständlich muss der Schalter 15 wieder geöffnet werden, bevor der Schalter 14 für eine Ankopplung der Kapazität 13 geschlossen wird.

## Patentansprüche

1. Sensoreinrichtung für ein Kraftfahrzeug, mit einer Steuer- und Auswerteeinrichtung (2) und wenigstens einer damit gekoppelten Sensorelektrode (4),
wobei die Sensorelektrode (4) als Leiterschleife ausgebildet ist, welche an zwei Kontaktstellen mit der Steuer- und Auswerteeinrichtung (2) gekoppelt ist,
wobei die Steuer- und Auswerteeinrichtung (2) eine Messschaltung (10) aufweist, welche derart ausgebildet ist, dass sie die Sensorelektrode (4) auf Kapazitätsänderungen überwacht,
**dadurch gekennzeichnet,**
**dass** die Steuer- und Auswerteeinrichtung (2) eine zeitweise aktivierbare Prüfschaltung (11) aufweist, welche die Integrität der Sensorelektrode und deren Kopplung an die Steuer- und Auswerteeinrichtung (2) prüft, wobei die Messschaltung an einem Ende der Sensorelektrode mit dieser gekoppelt ist und die Prüfschaltung am anderen Ende der Sensorelektrode mit dieser gekoppelt ist, und wobei die Prüfschaltung (11) eine ansteuerbare Schalteinrichtung (14) aufweist, um eine Prüfkapazität (13) zeitweise mit der Sensorelektrode (4) zu koppeln, so dass die Messschaltung (10) zusätzlich zu der Kapazität der Sensorelektrode auch die Kapazität der zu dieser in Reihe geschalteten Prüfkapazität (13) erfasst.

2. Sensoreinrichtung für ein Kraftfahrzeug, mit einer Steuer- und Auswerteeinrichtung (2) und wenigstens einer damit gekoppelten Sensorelektrode (4),
wobei die Sensorelektrode (4) in koaxialer Form ausgebildet ist und mit Innenleiter und Außenleiter mit der Steuer- und Auswerteeinrichtung (2) gekoppelt ist,
wobei die Steuer- und Auswerteeinrichtung (2) eine Messschaltung (10) aufweist, welche derart ausgebildet ist, dass sie die Sensorelektrode (4) auf Kapazitätsänderungen überwacht,
**dadurch gekennzeichnet,**
**dass** die Steuer- und Auswerteeinrichtung (2) eine zeitweise aktivierbare Prüfschaltung (11) aufweist, welche die Integrität der Sensorelektrode und deren Kopplung an die Steuer- und Auswerteeinrichtung (2) prüft, wobei die Messschaltung an einem Ende der Sensorelektrode mit dieser gekoppelt ist und die Prüfschaltung am anderen Ende der Sensorelektrode mit dieser gekoppelt ist, und wobei die Prüfschaltung (11) eine ansteuerbare Schalteinrichtung (14) aufweist, um eine Prüfkapazität (13) zeitweise mit der Sensorelektrode (4) zu koppeln, so dass die Messschaltung (10) zusätzlich zu der Kapazität der Sensorelektrode auch die Kapazität der zu dieser in Reihe geschalteten Prüfkapazität (13) erfasst.

3. Sensoreinrichtung nach Anspruch 1 oder 2, wobei die Prüfkapazität (13) aus einem Kondensatorbauteil gebildet ist.

4. Sensoreinrichtung nach einem der Ansprüche 1 bis 3, wobei die Prüfschaltung eine zweite Schalteinrichtung (15) aufweist, über welche die Prüfkapazität zum Entladen mit Masse koppelbar ist.

5. Sensoreinrichtung nach einem der vorangehenden Ansprüche, wobei die Prüfschaltung die Prüfkapazität gemäß einem in der Steuer- und Auswerteeinrichtung hinterlegten Zeitschema wiederholt zeitweise mit der Sensorelektrode koppelt und zeitweise von der Sensorelektrode entkoppelt, wobei die von der Messschaltung gemessenen Kapazitätswerte bei aktiver Prüfschaltung in der Steuer- und Auswerteeinrichtung auf Übereinstimmung mit dem hinterlegten Zeitschema untersucht werden.

6. Sensoreinrichtung nach einem der vorangehenden Ansprüche, wobei die Sensorelektrode als Leiterschleife ausgebildet ist, welche in einem flexiblen Kunststoffprofil aufgenommen und geführt ist.

## Claims

1. A sensor device for a motor vehicle, having a control and evaluation device (2) and at least one sensor electrode (4) coupled thereto,
wherein the sensor electrode (4) is constructed as a conductor loop, which is coupled to the control and evaluation device (2) at two contact points,
wherein the control and evaluation device (2) has a measuring circuit (10), which is constructed in such a manner that it monitors the sensor electrode (4) for capacitance changes,
**characterized**
**in that** the control and evaluation device (2) has a test circuit (11), which can be activated temporarily and tests the integrity of the sensor electrode and the coupling thereof to the control and evaluation device (2), wherein the measuring circuit is coupled to the sensor electrode at one end of the sensor electrode and the test circuit is coupled to the sensor electrode at the other end of the sensor electrode, and wherein the test circuit (11) has a controllable switching device (14), in order to temporarily couple a test capacitance (13) to the sensor electrode (4), so that, in addition to the capacitance of the sensor electrode, the measuring circuit (10) also records the capacitance of the test capacitance (13) connected in series to the sensor electrode.

2. A sensor device for a motor vehicle, having a control and evaluation device (2) and at least one sensor electrode (4) coupled thereto,
wherein the sensor electrode (4) is constructed in a coaxial shape and being coupled using the inner conductor and outer conductor to the control and evaluation device (2),
wherein the control and evaluation device (2) has a measuring circuit (10), which is constructed in such a manner that it monitors the sensor electrode (4) for capacitance changes,
**characterized**
**in that** the control and evaluation device (2) has a test circuit (11), which can be activated temporarily and tests the integrity of the sensor electrode and the coupling thereof to the control and evaluation device (2), wherein the measuring circuit is coupled to the sensor electrode at one end of the sensor electrode and the test circuit is coupled to the sensor electrode at the other end of the sensor electrode, and wherein the test circuit (11) has a controllable switching device (14), in order to temporarily couple a test capacitance (13) to the sensor electrode (4), so that, in addition to the capacitance of the sensor electrode, the measuring circuit (10) also records the capacitance of the test capacitance (13) connected in series to the sensor electrode.

3. The sensor device according to Claim 1 or 2, wherein the test capacitance (13) is formed from a capacitor component.

4. The sensor device according to one of Claims 1 to 3, wherein the test circuit has a second switching device (15), by means of which the test capacitance can be coupled for discharging to earth.

5. The sensor device according to one of the preceding claims, wherein the test circuit temporarily couples the test capacitance to the sensor electrode and temporarily decouples the test capacitance from the sensor electrode repeatedly according to a timing schedule stored in the control and evaluation device, wherein, if the test circuit is active, it is possible to investigate in the control and evaluation device if capacitance values measured by the measuring circuit match the stored timing schedule.

6. The sensor device according to one of the preceding claims, wherein the sensor electrode is constructed as a conductor loop, which is accommodated and routed in a flexible plastic profile.

## Revendications

1. Dispositif de détection pour un véhicule automobile, avec un dispositif de commande et d'évaluation (2) et au moins une électrode de détection (4) couplée à celui-ci,
dans lequel l'électrode de détection (4) est conçue comme une boucle conductrice, laquelle est couplée en deux points de contact au dispositif de commande et d'évaluation (2),
dans lequel le dispositif de commande et d'évaluation (2) comporte un circuit de mesure (10) conçu de manière à surveiller l'électrode de détection (4) quant à des variations de capacité,
**caractérisé en ce que**
le dispositif de commande et d'évaluation (2) comporte un circuit de contrôle (11) activable temporairement, lequel contrôle l'intégrité de l'électrode de détection et du couplage de celle-ci avec le dispositif de commande et d'évaluation (2), le circuit de mesure étant couplé à l'électrode de détection à une extrémité de celle-ci et le circuit de contrôle étant couplé à l'électrode de détection à l'autre extrémité de celle-ci, et le circuit de contrôle (11) comportant un dispositif de commutation actionnable (14) permettant de coupler temporairement une capacité de contrôle (13) avec l'électrode de détection (4), de manière à ce que le circuit de mesure (10) puisse également détecter, en plus de la capacité de l'électrode de détection (4), la capacité de la capacité de contrôle (13) raccordée en série à celle-ci.

2. Dispositif de détection pour un véhicule automobile, avec un dispositif de commande et d'évaluation (2) et au moins une électrode de détection (4) couplée à celui-ci,
dans lequel l'électrode de détection (4) présente une forme coaxiale, tout en étant couplée au dispositif de commande et d'évaluation (2) avec un conducteur interne et un conducteur externe,
dans lequel le dispositif de commande et d'évaluation (2) comporte un circuit de mesure (10) conçu de manière à surveiller l'électrode de détection (4) quant à des variations de capacité,
**caractérisé en ce que**
le dispositif de commande et d'évaluation (2) comporte un circuit de contrôle (11) activable temporairement, lequel contrôle l'intégrité de l'électrode de détection et du couplage de celle-ci avec le dispositif de commande et d'évaluation (2), le circuit de mesure étant couplé à l'électrode de détection à une extrémité de celle-ci et le circuit de contrôle étant couplé à l'électrode de détection à l'autre extrémité de celle-ci, et le circuit de contrôle (11) comportant un dispositif de commutation actionnable (14) permettant de coupler temporairement une capacité de contrôle (13) avec l'électrode de détection (4), de manière à ce que le circuit de mesure (10) puisse également détecter, en plus de la capacité de l'électrode de détection (4), la capacité de la capacité de contrôle (13) raccordée en série à celle-ci.

3. Dispositif de détection selon la revendication 1 ou 2, dans lequel la capacité de contrôle (13) est constituée d'une pièce de condensateur.

4. Dispositif de détection selon l'une des revendications 1 à 3, dans lequel le circuit de contrôle comporte un deuxième dispositif de commutation (15) permettant de coupler la capacité de contrôle à la masse pour la décharge.

5. Dispositif de détection selon l'une des revendications précédentes, dans lequel le circuit de contrôle couple temporairement la capacité de contrôle avec l'électrode de détection et la découple temporairement de l'électrode de détection, de façon répétée selon un schéma temporel enregistré dans le dispositif de commande et d'évaluation, dans lequel les valeurs de capacité mesurées par le circuit de mesure sont examinées dans le dispositif de commande et d'évaluation quant à leur concordance avec le schéma temporel enregistré tandis que le circuit de contrôle est actif.

6. Dispositif de détection selon l'une des revendications précédentes, dans lequel l'électrode de détection est conçue comme une boucle conductrice, laquelle est reçue et guidée dans un profilé en plastique souple.
